(19) Europäisches Patentamt
European Patent Office
Office européen des brevets

(11) **EP 3 907 560 A1**

(12) **EUROPEAN PATENT APPLICATION**

(43) Date of publication:
**10.11.2021 Bulletin 2021/45**

(51) Int Cl.:
***G03F 1/24*** *(2012.01)*

(21) Application number: **21170665.0**

(22) Date of filing: **27.04.2021**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.04.2020 JP 2020079089**

(71) Applicant: **Shin-Etsu Chemical Co., Ltd.
Tokyo (JP)**

(72) Inventors:
• **TERASAWA, Tsuneo**
 **Joetsu-shi (JP)**
• **KANEKO, Hideo**
 **Joetsu-shi (JP)**
• **INAZUKI, Yukio**
 **Joetsu-shi (JP)**
• **KOSAKA, Takuro**
 **Joetsu-shi (JP)**

(74) Representative: **Mewburn Ellis LLP
Aurora Building
Counterslip
Bristol BS1 6BX (GB)**

(54) **SUBSTRATE WITH FILM FOR REFLECTIVE MASK BLANK, AND REFLECTIVE MASK BLANK**

(57) A substrate and film combination for making a reflective mask blank, and a reflective mask blank, including a substrate (101), a multilayer reflection film (102) of Mo layers and Si layers, and a Ru protection film (103) is provided. The substrate and blank include a mixing layer containing Mo and Si existing between the Mo layer and Si layer, another mixing layer containing Ru and Si generating between the uppermost Si layer and the Ru protection film, the film and layers have thicknesses satisfying defined expressions.

# FIG.2

**Description**

TECHNICAL FIELD

The present invention relates to a reflective mask blank for manufacturing a reflective mask used for manufacturing semiconductor devices, and a substrate with a film for a reflective mask blank in which decrease in reflectance is suppressed even if a protection film is provided on a multilayer reflection film.

BACKGROUND

In a manufacturing process of semiconductor devices, a photolithography technique in which a circuit pattern formed on a transfer mask is transferred onto a semiconductor substrate (semiconductor wafer) through a reduction projection optical system with irradiation of exposure light onto the transfer mask is used repeatedly. Conventionally, a mainstream wavelength of the exposure light is 193 nm by argon fluoride (ArF) excimer laser light. A pattern with dimensions smaller than exposure wavelength has finally been formed by adopting a process called multi-patterning in which exposure processes and processing processes are combined multiple times.

However, since it is necessary to form still finer patterns under the continuous miniaturization of device patterns, EUV lithography techniques using, as exposure light, extreme ultraviolet (hereinafter referred to "EUV") light having a wavelength shorter than ArF excimer laser light are promising. EUV light is light having a wavelength of about 0.2 to 100 nm, more typically or specifically, light having a wavelength of around 13.5 nm. This EUV light has a very low transmission through substances and cannot be utilized for a conventional transmissive projection optical system or a mask, thus, a reflection type optical elemental device is applied. Therefore, a reflective mask is also proposed as a mask for the pattern transfer.

A reflective mask has a multilayer reflection film that is formed on a substrate and reflects EUV light, and a patterned absorber film that is formed on the multilayer reflection film and absorbs EUV light. The product (including a product on which a resist film ,may be present) before patterning the absorber film is called a reflective mask blank, and is used as a material precursor for the reflective mask. Hereinafter, a reflective mask blank that reflects EUV light is also referred to as an EUV mask blank. The EUV mask blank has a basic structure including a multilayer reflection film that is formed on a glass substrate and reflects EUV light, and an absorber film that is formed thereon and absorbs EUV light. As the multilayer reflection film, a Mo/Si multilayer reflection film which ensures a reflectance for EUV light by alternately laminating molybdenum (Mo) layers and silicon (Si) layers is usually used. On the other hand, as the absorber film, a material containing tantalum (Ta) or chromium (Cr) as a main component, which has a relatively large extinction coefficient with respect to EUV light, is usually used.

A protection film is formed between the multilayer reflection film and the absorber film to protect the multilayer reflection film. The protection film is provided for the purpose of protecting the multilayer reflection film to avoid damage of the multilayer reflection film in steps such as etching for forming a pattern in the absorber film, a pattern repair process for repairing detected defects after forming the pattern, and cleaning of the mask after forming the pattern. For the protection film, ruthenium (Ru) or a material containing Ru as a main component as disclosed in JP-A 2002-122981 (Patent Document 1) or JP-A 2005-268750 (Patent Document 2) is usually used. The thickness of the protection film is preferably 2.0 to 2.5 nm from the viewpoint of ensuring reflectance, however, is preferably at least 3 nm from the viewpoint of protecting the multilayer reflection film.

Citation List

Patent Document 1: JP-A 2002-122981
Patent Document 2: JP-A 2005-268750

THE INVENTION

A multilayer reflection film in which Mo layers and Si layers are alternately laminated can obtain a relatively high reflectance of about 66 to 68% with respect to EUV light. However, when a Ru film as a protection film is formed on the multilayer reflection film, the reflectance of EUV light irradiated to the surface of the protection film is decreased, typically with a difference of 1.5 to 3% although it depends on the thickness of the protection film. This decrease in reflectance tends to be progressively exacerbated during the steps of manufacturing a reflective mask, and in subsequent exposure to EUV light. It is a concern that the reflectance of the multilayer reflection film is lowered in this way due to the formation of the protection film.

2

The present invention has been made to address the above issues. A general aim herein is to provide new and useful reflective mask blanks and reflective masks. Preferred aims are to realize a reflective mask having a good pattern transfer ability, and having a multilayer reflection film in which decrease in reflectance of the multilayer reflection film due to formation of a protection film is suppressed, and ensuring a high reflectance for EUV light for a long period after processing into the reflective mask and after exposure using the reflective mask. Aspects of the invention include a substrate and film combination as a precursor for the reflective mask blank, a corresponding reflective mask blank and reflective mask, and the methods of making these.

With respect to a multilayer reflection film and a protection film in a reflective mask blank for reflecting EUV light (an EUV mask blank), the inventors have studied reflectance by repeated calculations with the use of simulation. As a result, as a substrate with a film for a reflective mask blank including a multilayer reflection film including molybdenum (Mo) layers and silicon layers (Si) alternately laminated with an uppermost silicon (Si) layer, and a protection film containing ruthenium (Ru) as a main component and formed contiguous to the uppermost silicon (Si) layer, further, as a reflective mask blank including the substrate with a film for a reflective mask blank with an absorber film and a conductive film, the inventors have found good properties for a substrate with a film for a reflective mask blank (and a reflective mask blank) in which one mixing layer containing Mo and Si is generated at one boundary portion between the molybdenum (Mo) layer and the silicon (Si) layer, and another mixing layer containing Ru and Si is generated at another boundary portion between the uppermost silicon (Si) layer and the protection film, and in which thicknesses of the film and layers defined below satisfy all of the following expressions (1) to (3):

$$5.3 \leq T_{upSi} + T_{RuSi} + T_{Ru}/2 \leq 5.5 \qquad (1)$$

$$1.1 \leq T_{Ru}/2 - (T_{Si} - T_{upSi}) \leq 1.3 \qquad (2)$$

$$3.0 \leq T_{Ru} \leq 4.0 \qquad (3)$$

wherein $T_{Ru}$ (nm) represents a thickness of the protection film, $T_{RuSi}$ (nm) represents a thickness of said another mixing layer at said another boundary portion between the uppermost silicon (Si) layer and the protection film, $T_{upSi}$ (nm) represents a thickness of the uppermost silicon (Si) layer exclusive of the mixing layers, and $T_{Si}$ (nm) represents a thickness of the silicon (Si) layer exclusive of the mixing layers in the periodic laminated structure below the uppermost silicon (Si) layer. The substrate with a film for a reflective mask blank and the reflective mask blank have a high initial EUV light reflectance, and decrease in reflectance of the multilayer reflection film due to the protection film is suppressed. Further, even when the protection film is present, as a reflectance of EUV light irradiated from the surface side of the protection film, a high reflectance can be maintained. Furthermore, in EUV lithography, in case of assuming the mask with 4X magnification under the condition of NA=0.33, an incident angle of EUV light to the reflective mask should be considered in a range of 6±4.7° (1.3 to 10.7°). We find that the present multilayer reflection film and protection film can ensure a high reflectance in the incident angle range of 1.3 to 10.7°.

A mixing layer containing Ru and Si is generated as a Ru/Si mix layer at a boundary portion of the two layers when the Ru layer is formed on the Si layer. Herein, the mixing layer containing Ru and Si is distinguished from the Ru layer and the Si layer. Meanwhile, a mixing layer is also generated as a Mo/Si mix layer at a boundary portion of a Mo layer and a Si layer. Both mix layers can be observed on the cross-section, for example, by TEM, and their thicknesses can be measured.

In one aspect, the invention provides a substrate with a film for a reflective mask blank including a substrate, a multilayer reflection film that is formed on a main surface of the substrate and reflects extreme ultraviolet (EUV) light, and a protection film that is formed contiguous to the multilayer reflection film, wherein the multilayer reflection film has a periodic laminated structure in which molybdenum (Mo) layers and silicon layers (Si) are alternately laminated with an uppermost silicon (Si) layer, and one mixing layer containing Mo and Si exists at one boundary portion between the molybdenum (Mo) layer and the silicon (Si) layer, the protection film contains ruthenium (Ru) as a main component, and another mixing layer containing Ru and Si is generated at another boundary portion between the uppermost silicon (Si) layer and the protection film, and thicknesses of the film and layers defined below satisfy all of the following expressions (1) to (3):

$$5.3 \leq T_{upSi} + T_{RuSi} + T_{Ru}/2 \leq 5.5 \qquad (1)$$

$$1.1 \leq T_{Ru}/2 - (T_{Si} - T_{upSi}) \leq 1.3 \qquad (2)$$

$$3.0 \leq T_{Ru} \leq 4.0 \qquad (3)$$

wherein $T_{Ru}$ (nm) represents a thickness of the protection film, $T_{RuSi}$ (nm) represents a thickness of said another mixing layer at said another boundary portion between the uppermost silicon (Si) layer and the protection film, $T_{upSi}$ (nm) represents a thickness of the uppermost silicon (Si) layer exclusive of the mixing layers, and $T_{Si}$ (nm) represents a thickness of the silicon (Si) layer exclusive of the mixing layers, in the periodic laminated structure below the uppermost silicon (Si) layer.

Preferably, in the substrate with a film for a reflective mask blank, a minimum reflectance $R_{min}$ (%) with respect to EUV light at an incident angle in a range of 1.3 to 10.7° satisfies the following expression (4):

$$R_{min} \geq 72 - 2 \times T_{Ru} \qquad (4)$$

wherein $T_{Ru}$ represents a thickness (nm) of the protection film.

In another aspect, the invention provides a reflective mask blank including the substrate with a film for a reflective mask blank, an absorber film that is formed on the protection film and absorbs the extreme ultraviolet (EUV) light, and a conductive layer formed on the opposite main surface of the substrate.

ADVANTAGEOUS EFFECTS

According to our proposals herein, we find that it is possible to realize a substrate with a film for a reflective mask blank in which a decrease in reflectance caused by formation of a protection film on a multilayer reflection film is suppressed. Further, by forming an absorber film on the protection film, it can be provided that a highly reliable reflective mask blank in which a prescribed reflectance is ensured with protecting the multilayer reflection film, even after being processed into a reflective mask.

BRIEF DESCRIPTION OF THE DRAWINGS

FIG. 1A is a schematic cross-sectional view of a main portion of a reflective mask blank structure embodying the present invention; FIG. 1B is a cross-sectional view of a main portion illustrating a state in which a resist is applied to the surface of the reflective mask blank of FIG. 1A; and FIG. 1C is a cross-sectional view of a main portion illustrating a patterned state in which the resist film has been patterned relative to the state of FIG. 1B, and then the absorber film etched to form an absorber film pattern.

FIG. 2 is a cross-sectional view of an upper portion of a multilayer reflection film and a protection film thereon, before forming an absorber film in the mask blank.

FIGS. 3A and 3B are graphs illustrating a reflectance of EUV light of a multilayer reflection film of the present type as a function of the thickness of an uppermost Si layer and the thickness of a mixing layer of Ru and Si, at an incident angle of light of 6° (FIG. 3A) and at an incident angle of light of 10° (FIG. 3B), respectively.

FIG. 4 is a graph illustrating an example in which the reflectance R of a multilayer reflection film is calculated as a function against the incident angle θ of EUV light.

FIGS. 5A to 5C are graphs illustrating that the reflectance R of a multilayer reflection film depending on an incident angle θ of EUV light is improved in varying a thickness of an uppermost Si layer, FIG. 5A illustrating calculated values which assume a protection film having a thickness of 3.0 nm, FIG. 5B illustrating calculated values which assume a protection film having a thickness of 3.5 nm, and FIG. 5C illustrating calculated values which assume a protection film having a thickness of 4.0 nm.

FIG. 6 is a flowchart for manufacturing a reflective mask blank embodying the invention.

FURTHER EXPLANATIONS: OPTIONS AND PREFERENCES

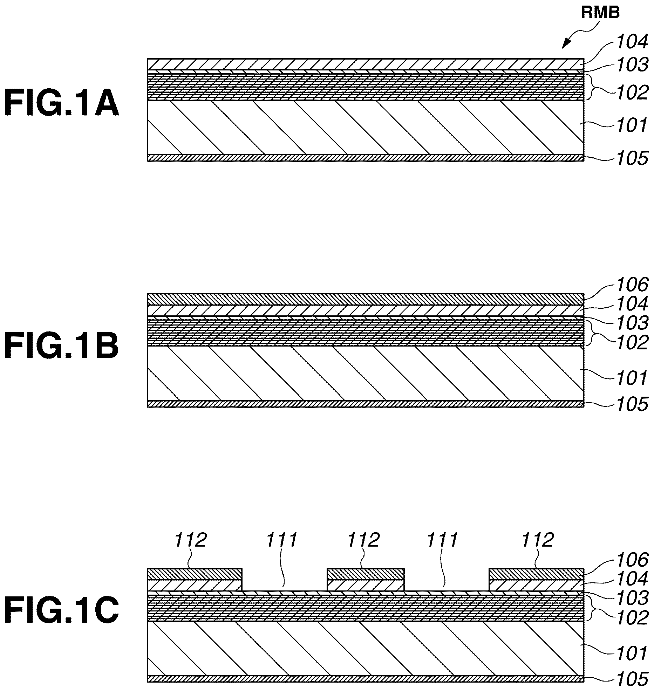

An outline of processes for manufacturing a reflective mask blank and a reflective mask for EUV exposure is illustrated in FIGS. 1A to 1C. FIG.1A is a cross-sectional view of a main portion of a reflective mask blank RMB. In the reflective mask blank RMB, a multilayer reflection film 102 that reflects EUV light, a protection film 103 for the multilayer reflection film 102, and an absorber film 104 that absorbs the EUV light are formed in that order on a main surface of a substrate 101 composed of a low thermal expansion material that is sufficiently flattened. On the other hand, a conductive film 105 for electrostatically holding the reflective mask on a mask stage of an exposure tool is formed on the other main surface (back side surface) of the substrate 101; opposite to the main surface on which the multilayer reflection film 102 is formed.

A substrate 101 having a coefficient of thermal expansion within $\pm 1.0 \times 10^{-8}/C°$, preferably $\pm 5.0 \times 10^{-9}/C°$ is generally used. Further, a main surface of the substrate 101 of the side to form an absorber film is surface-processed so as to have high flatness in the region where the absorber pattern is formed, and has a surface roughness RMS of preferably not more than 0.1 nm, more preferably not more than 0.06 nm.

The multilayer reflection film 102 is a multilayer film in which layers of a low refractive index material and layers of a high refractive index material are alternately laminated. For EUV light having an exposure wavelength of 13 to 14 nm, for example, a Mo/Si periodic laminated film in which molybdenum (Mo) layers and silicon (Si) layers are alternately laminated for e.g. about 40 cycles is used. This is known, and the materials and methods for forming the Mo and Si layers, and their number, may be selected in line with the skilled person's knowledge.

A protection film 103 is also called a capping layer, and is provided to protect the multilayer reflection film 102 when forming a pattern of the absorber film 104 thereon or when repairing the pattern. As a material of the protection film 103, silicon is used, and in addition, ruthenium, or a compound containing ruthenium is used. Typically niobium or zirconium is also used. The use of such ruthenium-containing protection film materials is known, as mentioned above. The thickness of the protection film is usually in the range of about 2.5 to 4 nm.

FIG. 1B illustrates a state in which a resist is applied to the surface of the reflective mask blank RMB of FIG. 1A. A pattern is drawn to a resist film 106, and a resist pattern is formed by using usual electron beam lithography. Then, the resist pattern is used as an etching mask, and the absorber film 104 thereunder is removed by etching. Thereby portions 111 cleared by etching 111, and absorber pattern portions 112 consisting of an absorption film pattern and the resist pattern, are formed as illustrated in FIG. 1C. After that, a reflective mask having a basic structure can be obtained by removing the remaining resist film pattern.

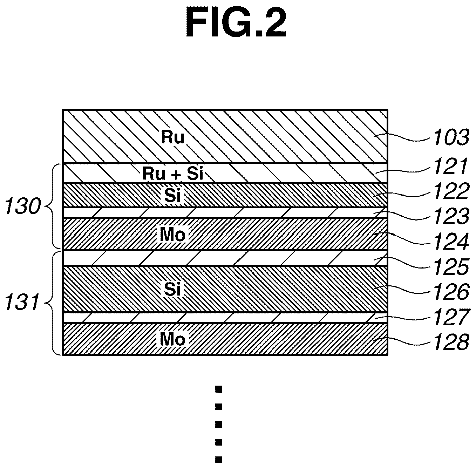

The following describes a film for a reflective mask blank including a multilayer reflection film that reflects EUV light implementing the present proposals. FIG. 2 illustrates a state in which a multilayer reflection film 102 that reflects EUV light and a protection film 103 therefor has been formed on the main surface of the substrate 101, and is a cross-sectional view of an upper portion of the substrate/film combination that includes the protection film 103 and the multilayer reflection film 102. In FIG. 2, the symbol "121" represents a mixing layer of Ru which is a main component of the protection film 103 and Si which is a component of the directly-contacted uppermost Si layer 122 thereunder (Ru/Si mixed layer), the symbol "126" represents a Si layer, the symbols "124" and "128" each represent a Mo layer, and the symbols "123", "125" and "127" each represent a mixing layer of Si and Mo (Mo/Si mixed layer).

Further, the symbol "130" represents a region (layer group) of an Mo/Si layer pair plus the mixing layer of Ru and Si 121 and the mixing layer of Si and Mo 123, at the uppermost portion of the multilayer reflection film. The symbol "131" represents a region (layer group) of an Mo/Si layer pair plus the mixing layers 125,127 of Si and Mo, under the uppermost pair of Mo/Si layers. Although not specifically illustrated in FIG. 2, further repeats of the same structures of the region (group) of the pair of Mo/Si layers 131 are successively formed under the region of the pair of Mo/Si layers 131 as indicated by the dots in FIG. 2.

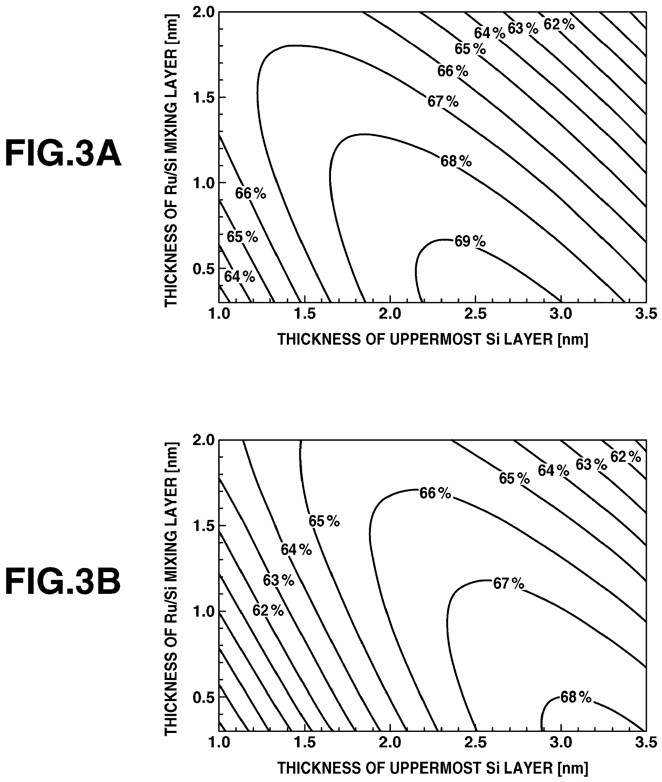

As a thickness (cycle length or layer group depth) of the region of the pair of Mo/Si layers, a thickness of 7.0 to 7.05 nm is normally adopted. Here, to evaluate reflectance of the multilayer reflection film by simulation, a thickness of a mixing layer 125 generated at the interface between a Si layer and a Mo layer thereon, and a thickness of a mixing layer 127 generated at the interface between a Mo layer and a Si layer thereon, are taken as 1.2 nm and 0.4 nm respectively, with reference to many actual measurement results taken using cross-section TEM observation. These values may be generally applied as an alternative to measurement, however TEM measurement is practical for the skilled person. As a result, it was confirmed that, when EUV light irradiates onto the multilayer reflection film at an incident angle of 6° with respect to the normal of the surface of the multilayer reflection film, the reflectance of the multilayer reflection film after forming the protection film 103 is decreased about 1.5% as a difference, compared with before forming the protection film 103. Actually, when the protection film 103 containing Ru as a main component is formed on the uppermost Si layer 122 thereon, a mixing layer of Ru and Si 121 is generated at the upper surface portion of the uppermost Si layer 122 directly under the protection film 103. A reflectance of the multilayer reflection film was calculated as a function of a thickness of the mixing layer of Ru and Si 121 and a thickness of the uppermost Si layer 122, whereby the result illustrated in FIG. 3A was obtained. Further, the reflectance at an incident angle of 10° was calculated, and the result illustrated in FIG. 3B was obtained.

FIGS. 3A and 3B indicate that a thinner mixing layer of Ru and Si 121 tends to have a higher reflectance. Further, FIGS. 3A and 3B indicate that for a given thickness of the Ru/Si mix layer 121, an optimal thickness of the uppermost Si layer 122 for maximizing the reflectance can be found. Accordingly, it was found that, in FIGS. 3A and 3B, the following relational expressions:

$$T1 \times 1.3 + T2 = 3.7$$

at an incident angle of 6°

$$T1 \times 1.3 + T2 = 4.5$$

at an incident angle of 10°

apply between the thickness T2 (nm) of the mixing layer of Ru and Si 121, and the thickness T1 (nm) of the uppermost Si layer 122 that can impart the maximum reflectance.

In other words, the values of T1 and T2 which can impart the maximum reflectance depend on the incident angle. For example, in the case that the thickness T2 of the mixing layer of Ru and Si 121 is 1.2 nm, the maximum reflectance can be obtained when the thickness of the uppermost Si layer 122 is 1.9 nm at an incident angle of 6°, while the thickness of the uppermost Si layer 122 is 2.5 nm at an incident angle of 10°. Further, in the case that the thickness T2 of the mixing layer of Ru and Si 121 is 1.4 nm, the maximum reflectance can be obtained when the thickness of the uppermost Si layer 122 is 1.8 nm at an incident angle of 6°, while the corresponding thickness of the uppermost Si layer 122 is 2.4 nm at an incident angle of 10°.

In actual use of a multilayer reflection film in a reflective mask for EUV exposure, EUV light may be incident on the multilayer reflection film over an incident angle range of from about 1.3° to 10.7°. Therefore, a combination of the thickness of the mixing layer of Ru and Si and the thickness of the uppermost Si layer is selected so as to obtain the maximum reflectance with respect to the intended or expected angle. However, since it is unfavorable that the reflectance is extremely lowered at any likely incident angle, a combination of thicknesses having an equable reflectance distribution and not significantly changing within the incident angle range of 1.3 to 10.7° should desirably be selected.

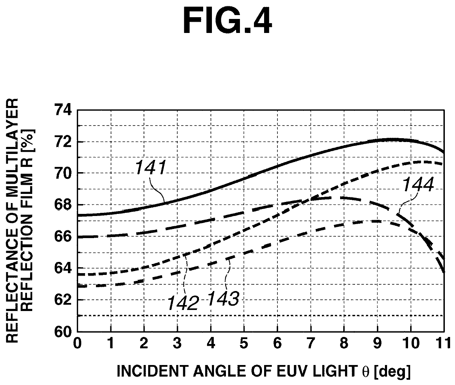

FIG. 4 is a graph illustrating calculation results of dependencies of the EUV light reflectance R on an incident angle θ in a multilayer reflection film. A range of the incident angle of 0° to 11°, and a cycle depth/length of 7.02 nm in the Mo/Si multilayer reflection film were set. In FIG. 4, curve 141 describes a reflectance of the Mo/Si multilayer reflection film (40 pairs) that does not have either of a mixing layer of Ru and Si or a Ru film as a protection film. When a Ru film having a thickness of 3.5 nm is formed thereon, the reflectance decreases as described by curve 142. For example, when the incident angle is 6°, the reflectance is decreased by about 3% as a difference. Further, the reflectance described by curve 143 was obtained by assuming, as thicknesses of the mixing layer in accordance with various experimental results, 0.4 nm-thickness of a mixing layer of the Mo and the component (Si) of the upside layer thereof, and 1.2 nm-thickness of a mixing layer of Si and the component (Mo) of the upside layer thereof. The reflectance described by curve 143 indicates that a reflectance of about 65% can be ensured at an incident angle of 6° or more, however, the reflectance is further decreased to 63% or low at an incident angle of 1.3°. Thus, when the thickness of the uppermost Si layer is reduced by about 0.8 nm, the reflectance described in curve 144 can be obtained. Particularly, the decreased reflectance is recovered to about 66% in a region of the incident angle of not more than 7°. Therefore, an equable reflectance distribution can be ensured by adjusting the thickness of the uppermost Si layer.

The above calculation is based on the assumption in which a thickness of the Ru film acting as a protection film for the Mo/Si multilayer reflection film is 3.5 nm. However, for other thicknesses, the combination of the thicknesses can be selected in the same manner. Specifically, reflectance distribution corresponding to curve 144 in FIG. 4 is obtained by assuming the thickness of the mixing layer of Ru and Si while changing the thickness of the uppermost Si layer. Then, a thickness of the uppermost Si layer that can obtain an equable reflectance distribution within a prescribed range of the incident angle may be selected. In addition, in forming the multilayer reflection film, a designed value of an initial thickness for the Si layer formed as the uppermost layer in the multilayer reflection film or an initial thickness of the Si layer in the periodic laminated structure below the uppermost Si layer may be the sum of the thickness of the mixing layer of Ru and Si and the thickness of the uppermost Si layer, assumed in the simulation.

By using a multilayer reflection film and a protection film that satisfy the above requirements, an initial reflectance can be maintained high over the entire incident angle of EUV light utilized in an EUV mask. Therefore, when an absorber film that absorbs EUV light, for example, an absorber film containing tantalum (Ta) or chromium (Cr) as a main component is formed on the multilayer reflection film, it is possible to provide a reflective mask blank (EUV mask blank) capable of realizing a reflective mask (EUV mask) having high transferability after the absorber film is patterned.

Example for Embodiment 1

In this embodiment, a Ru film as a protection film formed on a Mo/Si multilayer reflection film was selected. A thickness of the protection film is preferably 2.0 to 2.5 nm from the viewpoint of ensuring reflectance, however, the thickness of the protection film is set to at least 3.0 nm from the viewpoint of protecting the multilayer reflection film and is set to not more than 4 nm from the viewpoint of controlling significant decrease of the reflectance. Accordingly, in this case, the thickness $T_{Ru}$ of the protection film is within a range satisfying the following expression (3):

$$3.0 \leq T_{Ru} \leq 4.0 \qquad (3).$$

The thickness of the Ru film was set to 3.0 nm, 3.5 nm or 4.0 nm, and a structure of the multilayer reflection film which can impart an equable high reflectance distribution within an incident angle of EUV light of 1.3 to 10.7° was determined by simulation.

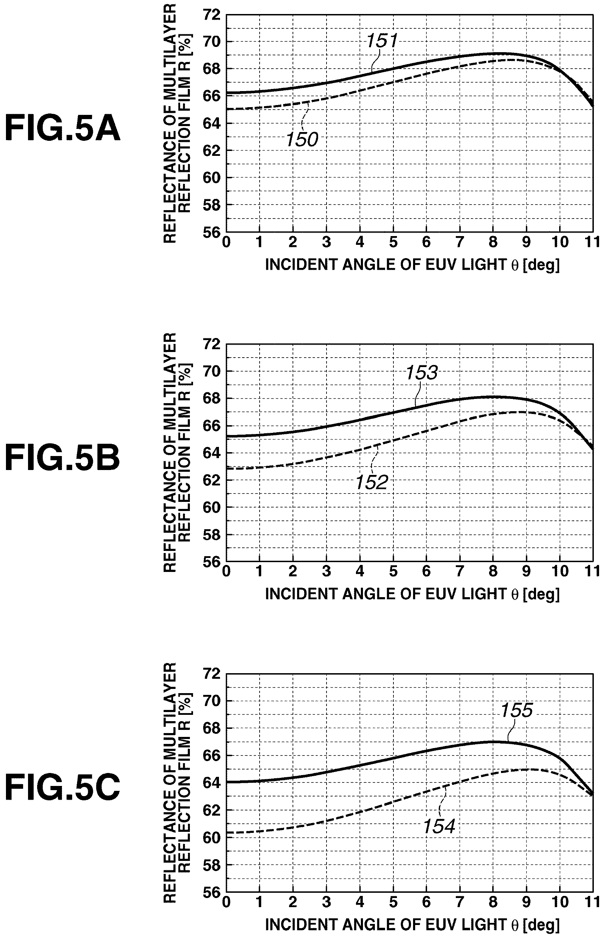

Next, a substrate with a film for an EUV reflective mask blank was manufactured by forming a multilayer reflection film that reflects EUV light and a protection film in this order on a main surface of a substrate composed of a low thermal expansion material. Structures of the multilayer reflection film in which the above-mentioned three kinds of the thicknesses were set to the Ru film are described with reference to FIG. 5 as follows.

First, a cycle length (layer group depth) of the Mo/Si multilayer reflection film (40 pairs) was set to 7.02 nm, and thicknesses of the Si layers and Mo layers before generating a mixing layer were set to 4.21 nm and 2.81 nm, respectively. If a mixing layer is not generated, the reflectance is maximized at an incident angle of EUV light of at least 9°, and the reflectance within a range of 1.3 to 10.7° results in unequable distribution as in the case mentioned above. However, in practice a mixing layer is generated, and the reflectance is significantly decreased within a region of large incident angle. Therefore, the above cycle length was selected as an initial cycle length, and thicknesses of mixing layers were set to 0.4 nm for the mixing layer of Mo and the component (Si) of the upside layer thereof (the layer above), and 1.2 nm for the mixing layer of Si and the component (Mo or Ru) of the upside layer thereof. Accordingly, thicknesses of Si layer and Mo layer exclusive of the mixing layers are 3.01 nm and 2.41 nm, respectively.

Here, it was assumed that a thickness of the protection film consisting of a Ru film is 3.0 nm. In this case, it was assumed that a mixing layer of Ru and Si having a thickness of 1.2 nm is generated on the upper portion of the uppermost Si layer. In other words, it was assumed that the substantive thickness of the uppermost Si layer is reduced by 1.2 nm compared with the value set for forming the film. The result described by curve 150 in FIG. 5A was obtained by calculating reflectance R of EUV light at an incident angle within an incident angle θ of 1.3 to 10.7°. Here, the reflectance described by curve 151 in FIG. 5A was obtained by reducing the thickness of the uppermost Si layer by 0.3 nm compared with the Si layer in the periodic laminated structure thereunder, i.e. by reducing the thickness set for forming the film by 0.3 nm. In case that an incident angle is narrowed down to a certain value, for example, 6°, the reflectance increases when the uppermost Si layer is formed further thinner. However, the reflectance was decreased within a range of an incident angle of 9° or more, not obtaining an equable reflectance distribution. So, the thickness of the uppermost Si layer was designed by reducing by 0.3 nm compared with the Si layer in the periodic laminated structure thereunder, realizing a reflectance of 66% or more.

Next, a decreased amount of the thickness of the uppermost Si layer (a thickness of a mixing layer of Ru and Si) when the thickness of the protection film consisting of Ru film was assumed to 3.5 nm was calculated. The same as above, it was assumed that a thickness of a mixing layer of Ru and Si is 1.2 nm. The reflectance described by curve 152 in FIG. 5B was obtained when the thickness of the uppermost Si layer was assumed as same as the thickness of the Si layers in the periodic laminated structure thereunder. So, the thickness of the uppermost Si layer was reduced by 0.55 nm compared with the Si layer in the periodic laminated structure thereunder. As a result, the reflectance described by curve 153 in FIG. 5B was obtained, realizing a reflectance of 65% or more within a range of an incident angle of 1.3 to 10.7°.

Further, a decreased amount of the thickness of the uppermost Si layer when the thickness of the protection film consisting of Ru film was assumed to 4.0 nm was calculated. As the same above, it was assumed that a thickness of a mixing layer of Ru and Si is 1.2 nm. The reflectance described by curve 154 in FIG. 5C was obtained when the thickness of the uppermost Si layer was assumed as same as the thickness of the Si layer in the periodic laminated structure thereunder. In this case, the reflectance was significantly decreased in a range of an incident angle of not more than 8°. So, the thickness of the uppermost Si layer was reduced by 0.8 nm compared with the Si layers in the periodic laminated structure thereunder. As a result, the reflectance described by curve 155 in FIG. 5C was obtained, realizing a reflectance of 64% or more within a range of an incident angle of 1.3 to 10.7°.

Accordingly, an equable reflectance distribution was obtained in each case of: setting the decreased amount of 0.3 nm in the thickness of the uppermost Si layer, and the thickness of 3.0 nm in the protection film consisting of Ru film; setting the decreased amount of 0.55 nm in the thickness of the uppermost Si layer, and the thickness of 3.5 nm in the protection film consisting of Ru film; or setting the decreased amount of 0.8 nm in the thickness of the uppermost Si layer, and the thickness of 4.0 nm in the protection film consisting of Ru film. Further, a relation represented by the following expression (4):

$$R_{min} \geq 72\text{-}2 \times T_{Ru} \qquad (4)$$

was resulted between the thickness $T_{Ru}$ (nm) of the protection film, and the minimum reflectance $R_{min}$ (%) with respect to EUV light within a range of an incident angle of 1.3 to 10.7°.

According to the above results, as a relation for realizing an equable reflectance distribution within a range of an incident angle of 1.3 to 10.7°, the following expression

$$T_{upSi}+T_{RuSi}+T_{Ru}/2 \leq 5.41$$

was resulted. In this expression, $T_{upSi}$ represents a thickness of the uppermost Si layer exclusive of mixing layers, $T_{RuSi}$ represents a thickness of a mixing layer at a boundary portion between the uppermost silicon (Si) layer and the protection film, and $T_{Ru}$ represents a thickness of the protection film, and each thickness is a numerical value expressed in unit of "nm".

Further, in each of the thicknesses of the Ru films, when the amount of decrease in the thickness of the uppermost Si layer varies within a range of $\pm 0.1$ nm, the reflectance varies in the low incident angle region. At an incident angle of 1.3°, it was found that the reflectance varies by about 0.5% as a difference with respect to the prescribed reflectance. Meanwhile, when the amount of decrease in the thickness of the uppermost Si layer varies within a range of $\pm 0.2$ nm, at an incident angle of 1.3°, the reflectance variation was increased to about 1% as a difference with respect to the prescribed reflectance. According to the above results, it was found that when an acceptable thickness variation is $\pm 0.1$ nm, a practical thickness range must satisfy the following expression (1):

$$5.3 \leq T_{upSi}+T_{RuSi}+T_{Ru}/2 \leq 5.5 \qquad (1).$$

Further, when the amount of decrease in the thickness of the uppermost Si layer is defined as $(T_{Si}\text{-}T_{upSi})$, it was found that the following expression:

$$T_{Ru}/2\text{-}(T_{Si}\text{-}T_{upSi}) = 1.2$$

holds between the amount of decrease, and the thickness $T_{Ru}$ of the Ru protection film. In this expression, $T_{upSi}$ represents a thickness of the uppermost Si layer exclusive of mixing layers, and $T_{Si}$ represents a thickness of the Si layer exclusive of the mixing layers, in the periodic laminated structure below the uppermost Si layer, and each thickness is a numerical value expressed in unit of "nm".

Also in this relational expression, under considering the acceptable thickness variation of a range of $\pm 0.1$ nm, it was found that a practical thickness range must satisfy the following expression (2):

$$1.1 \leq T_{Ru}/2\text{-}(T_{Si}\text{-}T_{upSi}) \leq 1.3 \qquad (2).$$

According to the above designed values, it was found that a substrate with a film for a reflective mask blank having a high minimum reflectance of preferably at least 64%, more preferably at least 65%, even more preferably at least 66% in a range of an incident angle of from 1.3 to 10.7° can be realized by forming a Mo/Si multilayer reflection film (40 pairs) having a cycle length of 7.02 nm and a protection film consisting of a Ru film, on a substrate composed of a low thermal expansion material.

Example for Embodiment 2

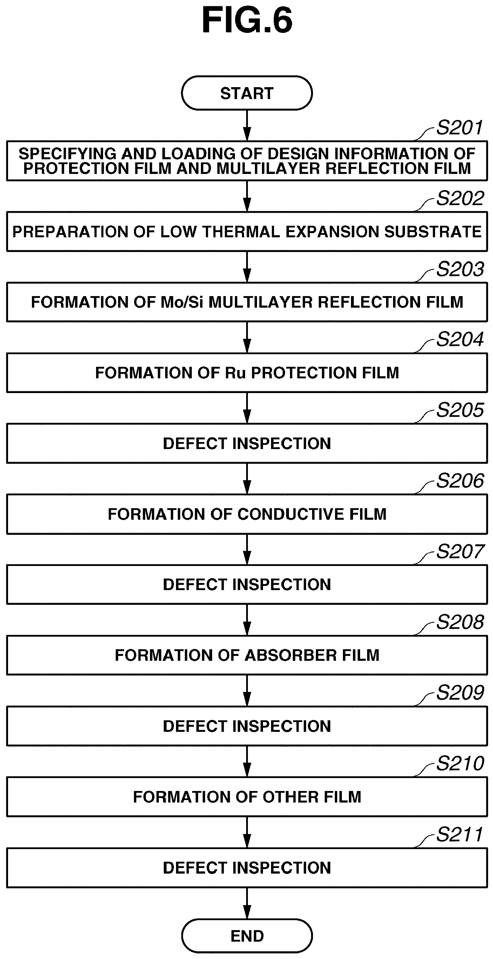

In this embodiment, a reflective mask blank was manufactured. An absorber film was formed on a protection film of a substrate with a reflective mask blank, and a conductive film was formed on another main surface (back side surface) which is opposite to the main surface on which the absorber film was formed. The manufacturing procedure is described with reference to FIG. 6.

First, design information for a basic structure such as a thickness in each layer of a protection film and a multilayer reflection film is specified and loaded (Step S201). Next, a substrate composed of a low thermal expansion material is prepared (Step S202). As the substrate, a substrate on which the front and back main surfaces have a prescribed surface roughness is prepared. Next, a Mo/Si (40 pairs) multilayer reflection film in which a Si layer is an uppermost layer, having a cycle length of 7.02 nm is formed on one of the main surfaces in accordance with the information for the basic structure (Step S203). In this regard, the thickness of the uppermost Si layer only is set to be 0.6 nm thinner than the thickness of the Si layers in the periodic laminated structure thereunder. Next, a protection film composed of Ru having a thickness of 3.5 nm is formed in Step S204. The multilayer reflection film and the protection film may be formed, respectively, by an ion beam sputtering method, a DC sputtering method or a RF sputtering method.

In Step S205, defects of the laminated films of the multilayer reflection film and the protection film are inspected, and defect location information and defect inspection signal information are saved into a recording medium. The defects to be inspected here are mainly phase defects which are involved in the multilayer reflection film, particles attached on the surface of the protection film, or the like.

Next, in Step S206, a conductive film is formed on the opposite surface (back surface) of the substrate composed of a low thermal expansion material, and defect inspection is performed in Step S207. The defect to be inspected in this defect inspection is mainly attached particles. The object of this inspection is to confirm that particle defects (size of about 1 μm or more) that deteriorate pattern transfer ability do not exist on the film when the formed reflective mask is electrostatically held on a mask stage of a pattern transfer tool.

In the defect inspection steps of Step S205 and Step S207, the substrate is cleaned or discarded when a critical defect is detected. On the other hand, the substrate is proceeded to next step when the defect is acceptable or no defect is detected. The step of forming the conductive film (Step S206) and the step of inspecting the conductive film (Step S207) may be performed prior to the step of forming the Mo/Si multilayer reflection film (Step S203).

In Step S208, an absorber film is formed on the protection film. The absorber film may also be formed by an ion beam sputtering method, a DC sputtering method or a RF sputtering method. After that, the surface of the absorber film is inspected for defects (Step S209).

According to the above method, the reflective mask blank having the basic structure is completed. If needed, other film(s) may be formed (Step S210). Here, the other film(s) include a thin hard mask as a processing aid layer for the absorber film, and a resist film. When the other film(s) are formed, the film(s) are inspected for defects (Step S211), and finally, the reflective mask blank is completed.

By this embodiment, even when a protection film having a thickness of 3.0 to 4.0 nm is formed on a Mo/Si multilayer reflection film, an absorber film can be formed on the protection film of a substrate with a film for a reflective mask blank that can control decrease of reflectance of the multilayer reflection film. Accordingly, a highly reliable reflective mask blank in which a high reflectance is ensured in a prescribed range of an incident angle (1.3 to 10.7°) of EUV light with protecting the multilayer reflection film can be provided.

Notes

In respect of numerical ranges disclosed in the present description it will of course be understood that in the normal way the technical criterion for the upper limit is different from the technical criterion for the lower limit, i.e. the upper and lower limits are intrinsically distinct proposals.

For the avoidance of doubt it is confirmed that in the general description above, in the usual way the proposal of general preferences and options in respect of different features of the substrate and film, mask blank, mask and methods constitutes the proposal of general combinations of those general preferences and options for the different features, insofar as they are combinable and compatible and are put forward in the same context.

The entire contents of Japanese Patent Application No. 2020-079089 filed on April 28, 2020, the priority of which is claimed herein, are hereby incorporated by reference as a precaution in case of error in translation or transcription.

**Claims**

1. A substrate and film for forming a reflective mask blank, and comprising a substrate (101), a multilayer reflection film (102) formed on a main surface of the substrate to reflect extreme ultraviolet (EUV) light, and a protection film (103) formed thereon contiguous to the multilayer reflection film, wherein

   the multilayer reflection film (102) has a periodic laminated structure in which molybdenum (Mo) layers and silicon (Si) layers are alternately laminated, with an uppermost silicon (Si) layer (122), and a Mo/Si mixed layer containing Mo and Si exists at a boundary portion between the molybdenum (Mo) layer and the silicon (Si) layer,

   the protection film (103) contains ruthenium (Ru) as a main component, and a Ru/Si mixed layer (121) containing Ru and Si exists at another boundary portion, between the uppermost silicon (Si) layer (122) and the protection film (103), and

   the thicknesses of the film and layers satisfy the following expressions (1) to (3):

$$5.3 \leq T_{upSi} + T_{RuSi} + T_{Ru}/2 \leq 5.5 \qquad (1)$$

$$1.1 \leq T_{Ru}/2 - (T_{Si} - T_{upSi}) \leq 1.3 \qquad (2)$$

$$3.0 \leq T_{Ru} \leq 4.0 \qquad (3)$$

wherein

$T_{Ru}$ (nm) represents the thickness of the protection film (103),
$T_{RuSi}$ (nm) represents the thickness of said Ru/Si mixed layer (121) at said another boundary portion between the uppermost silicon (Si) layer (122) and the protection film (103),
$T_{upSi}$ (nm) represents the thickness of the uppermost silicon (Si) layer (122) exclusive of the adjacent mixed layers (121,123), and
$T_{Si}$ (nm) represents the silicon (Si) layer thickness, exclusive of adjacent mixed layers, in the periodic laminated structure below the uppermost silicon (Si) layer (122).

2. Substrate and film of claim 1 wherein a minimum reflectance $R_{min}$ (%) with respect to EUV light at an incident angle in a range of 1.3 to 10.7° satisfies the following expression (4):

$$R_{min} \geq 72 - 2 \times T_{Ru} \qquad (4)$$

wherein $T_{Ru}$ represents a thickness (nm) of the protection film.

3. A reflective mask blank comprising
a substrate and film of claim 1 or 2,
an absorber film (104) formed on the protection film (103) thereof to absorb extreme ultraviolet (EUV) light, and
a conductive layer (105) formed on the opposite main surface of the substrate (101).

**FIG.1A**

RMB
— 104
— 103
— 102

— 101

— 105

**FIG.1B**

— 106
— 104
— 103
— 102

— 101

— 105

**FIG.1C**

*112*    *111*    *112*    *111*    *112*

— 106
— 104
— 103
— 102

— 101

— 105

# FIG.2

| | |
|---|---|
| Ru | 103 |
| Ru + Si | 121 |
| Si | 122 |
| | 123 |
| Mo | 124 |
| | 125 |
| Si | 126 |
| | 127 |
| Mo | 128 |

130

131

**FIG.3A**

THICKNESS OF Ru/Si MIXING LAYER [nm]

THICKNESS OF UPPERMOST Si LAYER [nm]

**FIG.3B**

THICKNESS OF Ru/Si MIXING LAYER [nm]

THICKNESS OF UPPERMOST Si LAYER [nm]

# FIG.4

FIG.5A

FIG.5B

FIG.5C

# FIG.6

START

*S201*

SPECIFYING AND LOADING OF DESIGN INFORMATION OF PROTECTION FILM AND MULTILAYER REFLECTION FILM

*S202*

PREPARATION OF LOW THERMAL EXPANSION SUBSTRATE

*S203*

FORMATION OF Mo/Si MULTILAYER REFLECTION FILM

*S204*

FORMATION OF Ru PROTECTION FILM

*S205*

DEFECT INSPECTION

*S206*

FORMATION OF CONDUCTIVE FILM

*S207*

DEFECT INSPECTION

*S208*

FORMATION OF ABSORBER FILM

*S209*

DEFECT INSPECTION

*S210*

FORMATION OF OTHER FILM

*S211*

DEFECT INSPECTION

END

| | Europäisches Patentamt European Patent Office Office européen des brevets | **EUROPEAN SEARCH REPORT** | Application Number EP 21 17 0665 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | US 2002/045108 A1 (LEE BYOUNG-TAEK [KR] ET AL) 18 April 2002 (2002-04-18) * paragraphs [0038] - [0053]; claim 3; figures 1-3 * ----- | 1-3 | INV. G03F1/24 |
| A | JP 2006 013280 A (HOYA CORP) 12 January 2006 (2006-01-12) * paragraph [0034] * ----- | 1-3 | |
| A | US 2012/231378 A1 (MIKAMI MASAKI [JP] ET AL) 13 September 2012 (2012-09-13) * paragraphs [0015] - [0023] * ----- | 1-3 | |

|  | TECHNICAL FIELDS SEARCHED (IPC) |
|---|---|
|  | G03F |

The present search report has been drawn up for all claims

| Place of search | Date of completion of the search | Examiner |
|---|---|---|
| Munich | 29 September 2021 | Eisner, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 17 0665

This annex lists the patent family members relating to the patent documents cited in the above-mentioned European search report.
The members are as contained in the European Patent Office EDP file on
The European Patent Office is in no way liable for these particulars which are merely given for the purpose of information.

29-09-2021

| Patent document cited in search report | | Publication date | Patent family member(s) | | Publication date |
|---|---|---|---|---|---|
| US 2002045108 | A1 | 18-04-2002 | JP | 5371162 B2 | 18-12-2013 |
| | | | JP | 2002122981 A | 26-04-2002 |
| | | | KR | 20020029590 A | 19-04-2002 |
| | | | US | 2002045108 A1 | 18-04-2002 |
| JP 2006013280 | A | 12-01-2006 | JP | 4553239 B2 | 29-09-2010 |
| | | | JP | 2006013280 A | 12-01-2006 |
| US 2012231378 | A1 | 13-09-2012 | CN | 102687071 A | 19-09-2012 |
| | | | EP | 2511944 A1 | 17-10-2012 |
| | | | EP | 2511945 A1 | 17-10-2012 |
| | | | JP | 5673555 B2 | 18-02-2015 |
| | | | JP | 5699938 B2 | 15-04-2015 |
| | | | JP | WO2011071123 A1 | 22-04-2013 |
| | | | JP | WO2011071126 A1 | 22-04-2013 |
| | | | KR | 20120106735 A | 26-09-2012 |
| | | | TW | 201131285 A | 16-09-2011 |
| | | | TW | 201131615 A | 16-09-2011 |
| | | | US | 2012196208 A1 | 02-08-2012 |
| | | | US | 2012231378 A1 | 13-09-2012 |
| | | | WO | 2011071123 A1 | 16-06-2011 |
| | | | WO | 2011071126 A1 | 16-06-2011 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002122981 A
- JP 2005268750 A
- JP 2020079089 A